# EUROPÄISCHE PATENTSCHRIFT

(11) **EP 3 284 271 B1**
(45) Veröffentlichungstag und Bekanntmachung des Hinweises auf die Patenterteilung: **16.12.2020**
(21) Anmeldenummer: 16715842.7
(22) Anmeldetag: 08.04.2016
(51) Int. Cl.: H04R 29/00, G08B 29/10, G01R 31/28

(54) **AUDIOSYSTEM, EINMESSMODUL, BETRIEBSVERFAHREN UND COMPUTERPROGRAMM**
AUDIO SYSTEM, CALIBRATION MODULE, OPERATING METHOD, AND COMPUTER PROGRAM
SYSTÈME AUDIO, MODULE D'ÉTALONNAGE ET PROCÉDÉ POUR LE FONCTIONNEMENT, ET PROGRAMME INFORMATIQUE

(30) Priorität: 13.04.2015 DE 102015206570
(43) Veröffentlichungstag der Anmeldung: 21.02.2018
(73) Patentinhaber: Robert Bosch GmbH, 70442 Stuttgart (DE)
(72) Erfinder: LERMER, Franz, 94431 Pilsting-Ganacker (DE)
(86) Internationale Anmeldenummer: PCT/EP2016/057744
(87) Internationale Veröffentlichungsnummer: WO 2016/166025

(56) Entgegenhaltungen:
- WO-A2-2006/050754
- WO-A2-2008/036992
- DE-U1-202015 001 656
- US-A1- 2006 182 288
- Anonymous: "Public Address Products Databook", , 7 April 2010 (2010-04-07), pages 1-150, XP055576453, Retrieved from the Internet: URL:s3.abbas.cz/PRODUKT/Katalog/Bosch_audi o/BOSCH_voice_catalog.pdf [retrieved on 2019-04-02]
- Anonymous: "Part 8 "Software" and part 9 "System Configuration"", Praesideo 3.3 - Digital Public Address and Emergency Sound System, 31 March 2009 (2009-03-31), pages 301-409, XP055576627, Retrieved from the Internet: URL:http://www.bosch-securitysystems.cz/st ore/manualy_en/PRS-33-200903-en.pdf [retrieved on 2019-04-02]
- Anonymous: "VPA PUBLIC ADDRESS AMPLIFIERS - INSTALLATION & SERVICE MANUAL" In: "VPA PUBLIC ADDRESS AMPLIFIERS - INSTALLATION & SERVICE MANUAL", 30 November 2010 (2010-11-30), Zenitel Norway AS, XP055576343, pages 1-22,

## Beschreibung

### Stand der Technik

Die Erfindung betrifft ein Audiosystem, ein Einmessmodul, ein Betriebsverfahren für das Audiosystem und das Einmessmodul, und ein Computerprogramm.

In vielen Audiosystemen - speziell bei Sprachalarmierungsanlagen, aber auch bei weiteren Audiosystemen, bei denen es auf permanente Verfügbarkeit und Betriebssicherheit ankommt - wird eine Pilottonüberwachung der Schaltungsteile, Geräte und Verbindungsleitungen eingesetzt. Damit kann die Forderung nach permanenter Überwachung der Audiowege (z.B. in der Norm EN54-16) zumindest für die Elektronik-Komponenten erfüllt werden.

Aus der WO 2006/050754 A2 ist ein Lautsprecherdurchsagesystem bekannt. Eine bidirektionale Kommunikation zwischen einer Steuereinrichtung und einer Überwachungseinrichtung überwacht das Vorhandensein und den Status der Lautsprecherleitung und der Lautsprecher ständig. Die Kommunikation erfolgt im Frequenzmultiplex auf der bestehenden Audioleitung vom Audio-Verstärker zu den Lautsprechern. In Kombination mit der bidirektionalen Datenkommunikation wird die Energieversorgung für die Überwachungseinrichtungen aus Audiofrequenzen extrahiert, vorzugsweise einem 20 kHz-Pilotton, der vom Audio-Verstärker erzeugt wird. Eine Filterung verhindert Wechselwirkungen zwischen Audiosignalen und / oder Kommunikationssignalen und / oder der Energieversorgung.

Die Druckschrift WO 2008/036992 A2 beschreibt ein Verfahren und eine Vorrichtung zur Überwachung von Lautsprecherlinien, bei welchem einer Lautsprecherlinie zumindest ein Wechselspannungssignal vorbestimmter Frequenz zugeführt wird, Spannung und Strom gemessen werden und daraus die Eingangsimpedanz der Linie ermittelt und mit einem Referenzwert verglichen wird. Zur Ermittlung einer mit einem Referenzwert zu vergleichenden Impedanz bei einem Messvorgang werden eine Vielzahl analoger Messwerte von Spannung und Strom in digitale Signale gewandelt und diese einer Fouriertransformation unterworfen.

In dem Produktkatalog "Public Address Products - Databook" von Bosch Security Systems aus dem Jahr 2010 wird die Verwendung von Pilottönen in Lautsprecheranlagen zur Überwachung beschrieben und eine automatische Einstellung des Pilottonpegels erwähnt.

### Offenbarung der Erfindung

Im Rahmen der Erfindung wird eine Einmesseinheit für ein Audiosystem gemäß Patentanspruch 1 vorgeschlagen. Bevorzugte oder vorteilhafte Ausführungsformen der Erfindung ergeben sich aus den Unteransprüchen, der nachfolgenden Beschreibung sowie den beigefügten Figuren.

Dabei enthält das Audiosystem ein Audio-Quellgerät zur Erzeugung eines Audio-Nutzsignals, ein Audio-Zielgerät zum Empfang des Audio-Nutzsignals, und einen Übertragungsweg für das Audio-Nutzsignal vom Audio-Quellgerät zum Audio-Zielgerät. Das Audiosystem enthält auch einen Generator zur Erzeugung eines in Richtung vom Audio-Quellgerät her zum Audio-Zielgerät hin über den Übertragungsweg zu übertragenden Pilottons, und mindestens einen am Übertragungsweg angeschlossenen Detektor für den Pilotton. Der Detektor weist einen Detektorausgang für ein von einer Detektion des Pilottons abhängiges Detektorsignal auf. Für den Pilotton ist - insbesondere im Generator - mindestens ein den Pilotton bestimmender Parameter veränderbar. Dabei ist erfindungsgemäß die Frequenz des Pilottons veränderbar. Im Detektor ist zudem der Detektions-Schwellwert veränderbar.

Die Einmesseinheit enthält eine Eingabeeinheit zur wahlfreien Einstellung des Parameters, wobei für zumindest einen Wert des Parameters die Detektorsignale aller Detektoren bei bekannt fehlerfreiem Übertragungsweg eine Detektion des Pilottons anzeigen.

Die Erfindung beruht auf folgenden Überlegungen: Das Audiosystem verfügt also über eine Pilottonüberwachung. Die Pilottonüberwachung umfasst einen Pilottongenerator, der in der Regel in einem Audio-Quellgerät, also einer Audioquelle (z.B. Audio-Controller, Sprechstelle, usw.) vorhanden ist. Sie umfasst auch - unter Verwendung eines Detektors - eine Pilottonauswertung in einem nachfolgenden Schaltungsteil oder Audiogerät (z.B. Audio-Verstärker, Überwachungseinheit, usw.), also einem Audio-Zielgerät. Nachfolgend heißt, dass der Detektor im Signalweg für das Nutzsignal stromabwärts des Generators angeordnet ist. Solange der Pilotton in der Pilottonauswertung detektiert wird, ist der Audioweg, also der Übertragungsweg zwischen Generator und Detektor in Ordnung. Sobald der Pilotton in der Auswertung nicht mehr erkannt wird, wird ein Fehler im Übertragungsweg gemeldet. Pilottonauswertungen können an verschiedenen Stellen im Übertragungsweg angeordnet sein, um den Fehler auf einen bestimmten Teil des Übertragungsweges einzugrenzen. Insbesondere sind sie auch so angeordnet, dass der gesamte relevante Übertragungsweg, der für das Nutzsignal zur Verfügung stehen soll, auch überwacht ist.

Anforderungen an die Pilottonüberwachung in diesem Zusammenhang können sein, dass die Überwachung bzw. der Pilotton - insbesondere neben dem und ohne das Audionutzsignal - unhörbar sein sollte und die Audioqualität des Audio-Nutzsignals nicht beeinträchtigen soll. Daher soll der Pilottongenerator auf einen möglichst geringen Pegel und eine geeignete Frequenz - insbesondere am Rand oder außerhalb des Hörbereichs und/oder des Übertragungsbereichs der angeschlossenen Lautsprecher - eingestellt werden.

In vielen bekannten Audiosystemen ist der Pilotton auf eine feste Frequenz und einen festen Pegel eingestellt, in anderen Systemen können die Parameter vom Installateur während der Systemkonfiguration manuell auf die jeweilige Situation angepasst werden. Die einmal festgelegte Konfiguration wird dann nicht mehr verändert.

Der Nachteil einer festen Pilottoneinstellung ist, dass Frequenz und Pegel so gewählt werden müssen, dass die Pilottonauswertung unter allen Systembedingungen funktioniert, z.B. bei unterschiedlichen Verstärkungen und unterschiedlichen Frequenzgängen. Pegel und Frequenz müssen somit auf der "sicheren Seite" liegen und sind daher oftmals zu hoch (Pegel) oder zu nah am hörbaren Bereich (Frequenz) eingestellt. Unter bestimmten Umständen (hochwertige Lautsprecher, hohe Verstärkungen) wird der Pilotton somit hörbar und/oder beeinträchtigt die Audioqualität des Audio-Nutzsignals.

"Wahlfrei" im Sinne der Erfindung bedeutet, dass stets zu beliebigem Zeitpunkt, auch im Betrieb des Audiosystems der Parameter bzw. dessen Wert einfach ein- bzw. nachstellbar ist. Eine laufende Anpassung an Gegebenheiten bzw.

Veränderungen im Audiosystem ist somit einfach und zeitnah möglich. So kann der Pilotton stets möglichst so eingestellt werden, dass die oben beschriebenen Effekte vermieden werden.

Der "Übertragungsweg" schließt neben einer eigentlichen Signalleitung auch alle sonstigen Komponenten im Signalweg mit ein, also z.B. zwischengeschaltete Audio-Quell- oder -Zielgeräte, die vom Nutzsignal und vom Pilotton durchlaufen werden. Zu "sonstigen Komponenten" im Signalweg zählen auch Audio-Signalprozessoren, Verstärker, Router, usw. Diese werden üblicherweise nicht als Audio-Quell- oder -Zielgeräte bezeichnet und sind hier zusätzlich aufgelistet. Eine allgemeine Bezeichnung hierfür ist "Audio-Signalverarbeitungsgeräte". Der Pilotton nimmt im Audiosystem den gleichen Weg wie das Audio-Nutzsignal.

Im Audiosystem können auch mehrere Audio-Quellgeräte und/oder Audio-Zielgeräte und/oder Übertragungswege und/oder Generatoren vorhanden sein. Grundsätzlich kann es mehrere Audio-Quellgeräte und Audio-Zielgeräte und somit auch mehrere Audio-Nutzsignale gleichzeitig in einem Audiosystem geben. Auch mehrere Generatoren können in einem Audiosystem vorkommen. Diese dienen zur Überwachung unterschiedlicher Audiowege, oder auch zur segmentweisen Überwachung eines Audioweges. Pro Audio-Quellgerät können sich mehrere Audio-Zielgeräte am selben Übertragungsweg befinden. Auch können im Audiosystem mehrere Audio-Quellgeräte mit je einem Übertragungsweg vorhanden sein. Der Pilotton ist vom Audio-Nutzsignal verschieden. In der Regel wird der Pilotton nicht nur auf einem Abschnitt des Übertragungsweges, sondern auf dessen gesamter Länge, insbesondere vom Audio-Quellgerät bis entferntesten Audio-Zielgerät und/oder dem Leitungsende des Übertragungsweges übertragen. Dort befinden sich dann entsprechende Detektoren. Im Übertragungsweg kann es allerdings auch mehrere Abschnitte geben, die getrennt mit jeweils einem Generator und Detektor ausgestattet sind. Dies wird z.B. dann vorgesehen, wenn sich viele einzelne Audiokomponenten und Verbindungsleitungen in einem Übertragungsweg befinden, um eine eventuelle Fehlerursache besser einkreisen zu können.

Im Detektor wird insbesondere üblicherweise nur der Pegel des Pilottons ausgewertet. In manchen Fällen erfolgt die Auswertung noch frequenzabhängig. Das Pilottonsignal wird dabei gefiltert. Die Pilottonüberwachung soll in erster Linie sicherstellen, dass Audiosignale grundsätzlich übertragen werden können. Bei der Einjustierung des Pilottons allerdings, also bei bekannt oder angenommen gutem Zustand des Übertragungsweges dient das Detektorsignal der Einjustierung des Pilottons und spiegelt damit die prinzipielle Übertragungsmöglichkeit des Audiosystems für den Pilotton wieder.

Es ist auch denkbar, den Pilotton nicht nur, insbesondere primär, für die Überwachung der Lautsprecherleitung einzusetzen, sondern auch, insbesondere hauptsächlich, für die Energieversorgung der Überwachungseinheit. Auch hierfür ist es sinnvoll, eine - insbesondere automatische - Pilottoneinstellung gemäß der Erfindung zu verwenden, z.B. um Spannungsabfälle auf der Lautsprecherleitung (z.B. abhängig von Länge und Querschnitt) sowie sonstige Pegeleinflüsse auszugleichen. Ansonsten müsste auch hier der Pegel manuell eingestellt werden.

Das Detektorsignal ist in einer bevorzugten Ausführungsform ein Binärsignal. Dieses zeigt die Detektion eines Pilottons am Detektor dadurch an, dass es einen seiner beiden Zustände annimmt, z.B. aktiviert ist. Ansonsten nimmt es den zweiten Zustand an, ist z.B. nicht aktiviert. Das Binärsignal zeigt also an, ob ein Pilotton detektiert ist oder nicht. Wenn es im regulären, d.h. Überwachungsbetrieb z.B. aktiviert ist, ist der Übertragungsweg (Übertragungsleitung, ...) fehlerfrei, wenn es nicht aktiviert ist, ist der Übertragungsweg fehlerbehaftet.

Gemäß der Erfindung kann anhand der Einmesseinheit also jederzeit und wahlfrei eine Einstellung bzw. Nachstellung des Pilottons erfolgen. So ist es möglich, diesen stets und mit möglichst kleinem Pegel und möglichst hoher bzw. niedriger Frequenz an den Übertragungsgrenzen des Audiosystems einzustellen. Die Einmessung erfolgt insbesondere in der Praxis allerdings hauptsächlich bei der Inbetriebnahme des Audiosystems und/oder bei regelmäßigen Überprüfungen der Anlage. Die Einmesseinheit ist insbesondere kein Gerät, sondern ein Softwaremodul.

Die Erfindung kann bei Sprachalarmierungssystemen, anderen professionellen Audiosystemen, Konferenzsystemen, Intercom-Systemen, insbesondere im Bereich Sicherheitstechnik eingesetzt werden. Ebenso ist eine Verwendung in anderen Audioanlagen denkbar, z.B. CAR-Audio.

In einer bevorzugten Ausführungsform der Erfindung weist die Einmesseinheit eine Ausgabeeinheit zur Ausgabe des Detektorsignals mindestens eines, vorzugsweise aller der Detektoren auf. So kann in der Einmesseinheit auch sofort kontrolliert werden, ob bei aktuell eingestelltem Parameter bzw. Pilotton tatsächlich alle Detektoren den Pilotton empfangen und die o.g. Grenzen besonders gut ausgenutzt werden. Die Einstellung der Parameter ist besonders einfach und ohne zusätzliche Hilfsmittel möglich.

Erfindungsgemäß enthält die Einmesseinheit ein auf den Parameter mindestens eines, vorzugsweise aller der Detektoren einwirkendes Einmessmodul, das mit dem jeweiligen Detektorausgang verbunden ist, und das dazu ausgebildet ist, den Wert des Parameters gemäß einem Einmesskriterium anhand des Detektorsignals automatisch derart einzustellen, dass bei bekannt fehlerfreiem Übertragungsweg das Detektorsignal eine Detektion des Pilottons anzeigt.

Das Einmessmodul wirkt auf die Parameter entweder unter Benutzung der Eingabeeinheit oder unter deren Umgehung, d.h. ohne diese, ein.

Diese Ausführungsform beruht auf folgenden Überlegungen: Eine manuelle Anpassung der Pilottonüberwachung hat den Nachteil, dass diese zeitaufwändig ist und somit zusätzliche Kosten verursacht, und dass ein gutes technisches Verständnis des Installateurs sowie Messgeräte zur Überprüfung der Funktionen erforderlich sind. Außerdem ist diese Methode fehleranfällig, weil womöglich nicht alle Systemzustände berücksichtigt werden.

Gemäß des Einmesskriteriums ist dagegen sichergestellt, dass bei bekannt fehlerfreiem Übertragungsweg zwischen Generator und Detektor - insbesondere also zwischen Audio-Quellgerät und Audio-Zielgerät - der Pilotton im Detektor detektiert ist.

Durch die vorgeschlagene automatische Einmessung der Pilottonüberwachung können insbesondere folgende Unterschiede, Abweichungen, Fehler usw. in Audiosystemen automatisch ausgeglichen werden: Pegelunterschiede - stets betrachtet für den am Detektor ankommenden Pilotton - durch Schaltungstoleranzen in den einzelnen beteiligten Geräten, Pegelabfälle durch lange Leitungen in den Audioübertragungswegen, Pegelunterschiede durch unterschiedliche Verstärkungsfaktoren in verschiedenen Audioverstärker-Modellen, Pegelabfälle, die durch den parallelen Anschluss mehrerer Audioverstärker an einem Controller-Ausgang bedingt sind, also durch höhere Belastung des Audioausgangs am Controller, Pegelunterschiede, die durch Verwendung des 70V-Anschlusses oder des 100V-Anschlusses am Ausgang des Audioverstärkers bedingt sind (3dB Pegelunterschied), unterschiedliche Frequenzgänge, die z.B. durch Einfügen von Übertragern in die Audiowege verursacht sind, unterschiedliche Frequenzgänge, die z.B. durch verschiedene Abtastraten oder durch Unterschiede in den eingesetzten Analog/Digital- und Digital/Analog-Wandlern in digitalen Audiosystemen bedingt sind, Pegelunterschiede, die durch Signalprozessor-Funktionen im Signalweg verursacht werden, z.B. durch Kompressoren, Limiter, automatische Lautstärkeregelungen, usw.

Insbesondere nach der Installation eines Audiosystems bzw. bei der Inbetriebnahme wird also eine automatische Pilotton-Einmessung gestartet. Sind in einem Audioübertragungsweg mehrere Detektoren angeordnet, kann dies für alle Detektoren erfolgen. Das Audiosystem kann somit automatisch auf die günstigsten Pegel- und Frequenzverhältnisse für den jeweiligen Anwendungsfall eingestellt werden und die Pilottonüberwachung im Hinblick auf Nicht-Hörbarkeit und Audioqualität selbständig optimiert werden. Durch den automatischen Einmessvorgang - insbesondere bei der System-Inbetriebnahme - werden Zeit und Kosten gespart, sowie Fehljustierungen vermieden. Die vorgeschlagene Methode ermöglicht den Einsatz von unterschiedlichen Audio-Komponenten in einem Audiosystem, weil Übertragungseigenschaften der Audiokomponenten im Hinblick auf die Pilottonüberwachung automatisch ausgeglichen werden. Die vorgeschlagene Methode ermöglicht unterschiedliche Systemaufbauten, weil Einflüsse durch lange Leitungen, Parallelschaltung von Audioverstärkern, unterschiedliche Verstärkungsfaktoren, Belastung von Audioausgängen, usw. automatisch ausgeglichen werden.

Gemäß dieser Ausführungsform der Erfindung erfolgt also eine automatische Pilottoneinstellung in Audiosystemen. Insbesondere erfolgt eine automatische und optimierte Einstellung des Pilottonpegels und der Pilottonfrequenz zur Anpassung an die Übertragungseigenschaften des Audiosystems bei Verwendung unterschiedlicher Geräte und Systemkonfigurationen.

Erfindungsgemäß ist das Einmesskriterium derart ausgebildet, dass das Einmessmodul den Wert ausgehend von einem vorgebbaren Startwert aus auf einen Grenzwert hin abgesenkt oder erhöht, bei dem das Detektorsignal gerade noch eine Detektion des Pilottons anzeigt.

Ausgehend von einer festgelegten bzw. vorgebbaren Grundeinstellung (Startwert) wird also z.B. der Pegel solange erhöht, bis die Pilotauswertung gerade anspricht (Erreichen des Grenzwertes) und die Übertragung des Pilottons über den jeweiligen Audioweg erfolgreich erkannt wurde. Sind in einem Audioweg mehrere Pilottonauswertungen hintereinander vorhanden, so wird der Pilottonpegel solange erhöht, bis alle Auswertungen einen Pegel über ihrem jeweiligen Schwellwert erkannt haben. Umgekehrt kann es auch vorkommen, dass der Pilotton schon bei der festgelegten Grundeinstellung (Startwert) in allen Pilottonauswertungen erkannt wird. In diesem Fall wird der Pegel des Pilottons reduziert, bis der Schwellwert (Grenzwert) in der Pilottonauswertung (bzw. einer von mehreren Pilottonauswertungen in einem Audioweg) unterschritten wird. Nach Unterschreitung des Schwellwerts wird der Pilottonpegel solange auf den Grenzwert erhöht, bis der Pilotton wieder sicher und dauerhaft in der Pilottonauswertung erkannt wird.

Auf ähnliche Art wird die Frequenz des Pilottongenerators optimiert. Dabei wird (ausgehend vom Startwert) die Frequenz des Generators im oberen Audioübertragungsbereich solange erhöht, bis man die Grenzfrequenz des Systems überschreitet und es somit zu einem Pegelabfall in der Pilottonauswertung kommt. Sobald ein Pegelabfall in der Auswertung erkannt wird, wird die Frequenz des Generators auf eine zuvor noch erfolgreich detektierte Frequenz als Grenzwert zurückgestellt. Ebenso kann im unteren Audioübertragungsbereich die Generatorfrequenz solange vom Startwert aus verringert werden, bis ein Pegelabfall in der Auswertung erkannt wird. Anschließend wird die Frequenz des Generators auch wieder auf eine zuvor noch erfolgreich erkannte Frequenz als Grenzwert hochgestellt.

Gemäß dieser Ausführungsform der Erfindung wird also der Pegel für die Pilottonüberwachung von Audiowegen automatisch auf den minimal erforderlichen Pegel eingestellt. Die Frequenz für die Pilottonüberwachung von Audiowegen wird automatisch auf die höchstmögliche Frequenz am oberen Audioübertragungsbereich bzw. alternativ auf die niedrigste mögliche Frequenz am unteren Audioübertragungsbereich eingestellt. Der Pilotton für die Überwachung von Audiowegen wird durch Reduzierung des Pegels und Verwendung einer Frequenz am Rande des Audioübertragungsbereichs automatisch auf möglichst unhörbar eingestellt. Gleichzeitig wird die Audioqualität im Übertragungsbereich möglichst gering beeinflusst.

Gemäß der Erfindung ist das Einmesskriterium derart ausgebildet, dass das Einmessmodul den Wert des Parameters vom Grenzwert aus um einen Abstandswert in diejenige Richtung abgesenkt oder erhöht, in der das Detektorsignal die Detektion des Pilottons sicher anzeigt.

Die Richtung des "sicheren" Anzeigens ist diejenige Richtung, die sich vom Grenzwert weg entgegen der Richtung erstreckt, in der der Pilotton nicht mehr detektiert wird. Hierbei wird angenommen dass der Grenzwert den Wertebereich des Parameters lokal in zwei Bereiche unterteilt. Im ersten Bereich findet keine Detektion des Pilottons statt, im zweiten schon. Es wird außerdem angenommen, dass die Detektion "sicherer" wird, wenn sich der Wert vom Grenzwert weg in den zweiten, also den "Detektions-"Bereich hinein bewegt.

Durch die Entfernung von der Erkennungsgrenze weg kann erreicht werden, dass auch während des Betriebs des Audiosystems dauerhaft eine sichere Pilottonerkennung erfolgt: Der Pilottonpegel wird nach Ansprechen der Pilottonauswertung noch weiter erhöht und auf einige dB über dem Schwellwert der Auswertung eingestellt. Entsprechend werden die Frequenzen von der oben ermittelten Untergrenze aus etwas weiter erhöht oder von der Obergrenze aus abgesenkt, um einen sicheren Abstand zu den möglichen Frequenzgrenzen zu erreichen. So werden Reserven bezüglich Pegel und Frequenz im Pilotton vorgesehen, um z.B. kleinen Veränderungen im Audiosystem vorzubeugen, die ansonsten eine Pilottonerkennung zunichtemachen würden.

Erfindungsgemäß ist der Parameter eine Frequenz des Pilottons. Diese Ausführungsform wurde weiter oben bereits mitbeschrieben. Amplitude und Frequenz des Pilottons sind besonders einfach einstellbar auszuführen.

Im Rahmen der Erfindung wird auch ein Audiosystem gemäß Patentanspruch 4 vorgeschlagen, das das oben beschriebene Audiosystem und die beschriebene Einmesseinheit enthält. Die Eigenschaften und Vorteile des Audiosystems wurden bereits im Zusammenhang mit der erfindungsgemäßen Einmesseinheit beschrieben.

Im Rahmen der Erfindung wird auch ein Verfahren gemäß Anspruch 5 zum Betreiben einer oben beschriebenen Einmesseinheit oder eines oben beschriebenen Audiosystems vorgeschlagen. Dabei wird der Parameter so eingestellt, dass die Detektorsignale aller Detektoren bei bekannt fehlerfreiem Übertragungsweg eine Detektion des Pilottons anzeigen. Die Eigenschaften und Vorteile des Verfahrens wurden bereits im Zusammenhang mit der erfindungsgemäßen Einmesseinheit beschrieben.

In einer bevorzugten Ausführungsform wird das Verfahren vor und/oder bei Inbetriebnahme und/oder während des laufenden Betriebs des Audiosystems durchgeführt. In der Regel wird das Verfahren nicht vor der Inbetriebnahme durchgeführt. Das Audiosystem muss zuvor komplett aufgebaut, verdrahtet und konfiguriert werden. Es ist jedoch die Eingabe von Verstärkungswerten, Leitungslängen/Impedanzen, usw. in ein Konfigurationsprogramm möglich, um die Pilottoneinstellungen schon vor dem Aufbau des Audiosystems simulieren und optimieren zu können. Insbesondere wird es zu einem späteren Zeitpunkt nach der Inbetriebnahme bzw. ersten Durchführung, insbesondere zyklisch wiederkehrend, erneut ausgeführt. Eine erneute Ausführung des Verfahrens erfolgt insbesondere hauptsächlich bei den regelmäßigen Anlagen-Inspektionen. Inspektionen sind von verschiedenen Normen zyklisch gefordert.

Somit wird sichergestellt, dass nicht nur zu Beginn, sondern auch während des späteren bzw. weiteren Betriebs des Audiosystems der Pilotton vorteilhaft, wie oben erläutert eingestellt ist.

Im Rahmen der Erfindung wird auch ein Computerprogramm mit Programmcode-Mitteln vorgeschlagen, um alle Schritte des o.g. Verfahrens durchzuführen, wenn das Programm auf einem Computer und/oder dem o.g. Einmessmodul oder dem o.g. Audiosystem ausgeführt wird. Die Eigenschaften und Vorteile des Computerprogramms wurden bereits im Zusammenhang mit der erfindungsgemäßen Einmesseinheit bzw. dem o.g. Verfahren beschrieben.

Weitere Merkmale, Vorteile und Wirkungen der Erfindung ergeben sich aus der nachfolgenden Beschreibung eines bevorzugten Ausführungsbeispiels der Erfindung sowie der beigefügten Figuren. Dabei zeigen in einer schematischen Prinzipskizze:
Fig. 1 eine Pilottonüberwachung in einem Audiosystem,
Fig. 2 einen automatischen Einmessvorgang für eine Amplitude des Pilottons,
Fig. 3 einen automatischen Einmessvorgang für eine Frequenz des Pilottons.

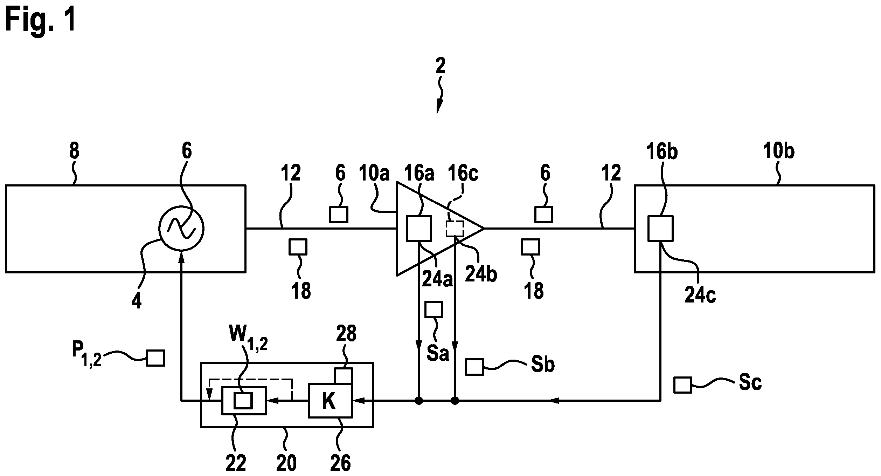

Figur 1 zeigt ein Beispiel für eine Pilottonüberwachung in einem Audiosystem 2, das insbesondere Teil eines größeren Audiosystems ist. Ein Audio-Quellgerät 8, hier ein Audio-Controller erzeugt im Betrieb ein Audio-Nutzsignal 18, das über einen Übertragungsweg 12 (hier zunächst eine NF-Audio-Leitung) zu einem ersten Audio-Zielgerät 10a, hier einem entlang dem Übertragungsweg 12 nachfolgenden Verstärker, übertragen wird. Alternativ und nicht dargestellt können im Audiosystem 2 mehrere Audio-Quellgeräte, Audio-Zielgeräte, Übertragungswege, Generatoren, Detektoren, usw. vorkommen. Im Verstärker wird das Nutzsignal 18 verstärkt und über den weiteren Übertragungsweg 12 (jetzt eine 100V-Audioleitung, auch als 100V-Lautsprecherleitung bezeichnet, oder alternativ auch eine beliebige niederohmige Lautsprecherleitung) an ein zweites Audio-Zielgerät 10b, hier eine Überwachungseinheit, übertragen. Das zweite (oder weitere) Zielgerät ist alternativ ein Lautsprecher mit integrierter Überwachungseinheit. Dort wird das Audiosignal über einen nicht dargestellten Lautsprecher ausgegeben. Der Übertragungsweg 12 durchläuft auch das Audio-Zielgerät 10a.

Zur laufenden Kontrolle bzw. Überprüfung aller genannten Komponenten des Audiosystems 2 ist eine Pilottonüberwachung vorgesehen. Die Komponenten sind alle Geräte sowie die Übertragungswege. Ein Generator 4 für einen symbolisch dargestellten Pilotton 6 ist im Audio-Quellgerät 8 vorgesehen. Der Pilotton 6 wird ebenfalls über den Übertragungsweg 12 übertragen, entweder zusammen mit oder auch ohne Nutzsignal. Eine Auswertung des Pilottons 6 erfolgt im ersten Audio-Zielgerät 10a. Eine weitere Auswertung des Pilottons 6 erfolgt im zweiten Audio-Zielgerät 10b entlang des Übertragungsweges 12 nach dem Audio-Zielgerät 10a. Für eine segmentweise Überwachung ist alternativ ein zweiter Pilotton (Generator) im Verstärker eingebaut. Damit sind die NF-Audioleitung und die 100V-Audioleitung getrennt überwachbar. Die Überwachung erfolgt durch einen jeweiligen Detektor 16a,b im jeweiligen Audio-Zielgerät 10a,b.

Alternativ sind im Audio-Zielgerät 10a zwei Detektoren 16a,c für eine jeweilige Pilottonauswertung eingebaut. Eine erste Auswertung anhand des Detektors 16a am Eingang ermöglicht die Überwachung des Audioweges vom Audio-Quellgerät 8 (Audio-Controller) zum Audio-Zielgerät 10a (Verstärker). Eine weitere Überwachung anhand des Detektors 16c am Verstärkerausgang ermöglicht die Überwachung des Audio-Zielgerätes 10a selbst, d.h. der enthaltenen Verstärkungsstufe.

Im Generator sind zwei Parameter P1,2 des Pilottons 6, nämlich dessen Amplitude und dessen Frequenz veränderbar. Eine Einmesseinheit 20 enthält eine Eingabeeinheit 22 für Werte W1,2 der Parameter P1,2. Die Eingabeeinheit wird eigentlich nur für eine manuelle Einstellung der Parameterwerte, oder für die Eingabe der Startwerte benötigt. Die Startwerte könnten im Audio-System aber auch fest vorgegeben sein. Auf die Eingabeeinheit kann alternativ daher auch verzichtet werden, bzw. ist diese nur optional vorgesehen.

Die Detektoren 16a-c enthalten jeweilige Detektorausgänge 24a-c, an denen jeweilige Detektorsignale Sa-c ausgegeben werden. Die Einmesseinheit 20 enthält auch eine Ausgabeeinheit 28 zur Anzeige der Parameter P1,2 bzw. deren Werte W1,2. Alternativ bzw. zusätzlich macht es Sinn, wenn die Ausgabeeinheit 28 auch die Zustände der Detektorsignale Sa-c anzeigt.

Die Einmesseinheit 20 enthält ein Einmessmodul 26. Dieses wirkt auf die Parameter S1,2 bzw. deren Werte W1,2 ein. Dies erfolgt entweder über die Eingabeeinheit 22 oder unter deren Umgehung (gestrichelt angedeutet) direkt am Generator 4. Das Einmessmodul 26 ist außerdem mit den Detektorausgängen 26a-c verbunden. Das Einmessmodul 26 stellt die Werte der Parameter P1,2 gemäß einem Einmesskriterium K anhand der Detektorsignale Sa-c automatisch derart ein, dass bei bekannt fehlerfreiem Übertragungsweg 12 und bei bekannt fehlerfreiem Audio-Zielgerät 10a das Detektorsignal Sa-c eine Detektion des Pilottons 6 anzeigen.

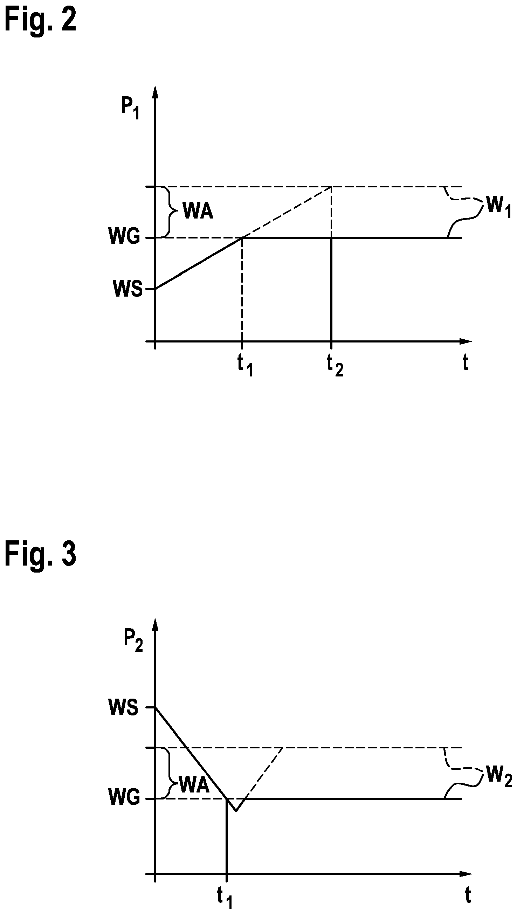

Fig. 2 zeigt einen automatischen Einmessvorgang über der Zeit t, wie er vom Einmessmodul 26 durchgeführt wird. Eine Amplitude als Parameter P1 des Pilottons 6 wird zunächst auf einen Startwert WS gesetzt. Da noch nicht alle Detektoren 16a-c den Pilotton 6 detektieren, was anhand der Detektorsignale Sac erkannt wird, wird die Amplitude erhöht. Ab dem Grenzwert WG zum Zeitpunkt t1 detektieren alle Detektoren 16a-c den Pilotton 6. Der Parameter P1 wird daher beim Grenzwert WG gehalten.

In einer alternativen Variante wird nach Erkennung des Pilottons 6 durch alle Detektoren 16a-c der Parameter P1 noch um einen Abstandswert WA weitererhöht, um einen "Sicherheitsabstand" zur Grenze bzw. dem Grenzwert WG zu erhalten. Nun detektieren alle Detektoren 16a-c den Pilotton 6 sicher auch dann noch, wenn sich die Übertragungsbedingungen für den Pilotton 6 verschlechtern, d.h. der Grenzwert WG höher ansteigt. In einem nicht dargestellten umgekehrten Fall liegt der Startwert WS über dem Grenzwert WG. In diesem Fall wird die Generator-Amplitude verringert, bis der Pilotton nicht mehr von allen Detektoren 16a-c erkannt wird. Danach wird die Generator-Amplitude wieder erhöht, bis alle Detektoren den Pilotton erkannt haben bzw. bis zum Erreichen das Abstandswertes WA.

Fig. 3 zeigt einen erfindungsgemäßen Einmessvorgang durch das Einmessmodul 26 anhand des Parameters P2, nämlich der Frequenz des Pilottons 6. Diese wird ausgehend von einem Startwert WS, bei dem bereits alle Detektoren 16a-c den Pilotton 6 detektieren, abgesenkt. Ab Unterschreitung des Grenzwertes WG detektieren nicht mehr alle Detektoren 16a-c den Pilotton 6. Der Parameter P2 wird daher wieder bis zum Grenzwert WG angehoben, damit wieder alle Detektoren 16a-c den Pilotton 6 gerade noch detektieren. Auch hier kann alternativ anschließend der Parameter P2 wieder um einen "Sicherheitsabstand" um einen Abstandswert WA wie oben mit gleichem Effekt erhöht werden. In einem nicht dargestellten alternativen Beispiel ergibt sich ein entsprechender Vorgang bei hohen Frequenzen am oberen Ende des Übertragungsbereichs: Die Frequenz wird ausgehend von einem Startwert WS, bei dem alle Detektoren 16a-c den Pilotton 6 detektieren, erhöht. Ab Überschreitung des Grenzwertes WG detektieren nicht mehr alle Detektoren 16a-c den Pilotton 6. Der Parameter P2 wird daher wieder bis zum Grenzwert WG abgesenkt, damit wieder alle Detektoren 16a-c den Pilotton 6 gerade noch detektieren. Auch hier kann alternativ anschließend der Parameter P2 wieder um einen "Sicherheitsabstand" um einen Abstandswert WA wie oben mit gleichem Effekt abgesenkt werden.

## Patentansprüche

1. Einmesseinheit (20) für ein Audiosystem (2), wobei das Audiosystem (2) enthält:
- ein Audio-Quellgerät (8) zur Erzeugung eines Audio-Nutzsignals (18),
- ein Audio-Zielgerät (IOa,b) zum Empfang des Audio-Nutzsignals (18),
- einen Übertragungsweg (12) für das Audio-Nutzsignal (18) vom Audio-Quellgerät (8) zum Audio-Zielgerät (IOa,b),
- einen Generator (4) zur Erzeugung eines in Richtung vom Audio-Quellgerät (8) her zum Audio-Zielgerät (IOa,b) hin über den Übertragungsweg (12) zu übertragenden Pilottons (6),
- mindestens einen am Übertragungsweg (12) angeschlossenen Detektor (16a-c) für den Pilotton (6), mit einem Detektorausgang (24a-c) für ein von einer Detektion des Pilottons (6) abhängiges Detektorsignal (Sa-c),
- wobei mindestens ein den Pilotton (6) bestimmender Parameter (P2) veränderbar ist,
wobei die Einmesseinheit (20) eine Eingabeeinheit (22) zur wahlfreien Einstellung des Parameters (P2) und für die Eingabe von Startwerten des Parameters (P2) enthält, wobei für zumindest einen Wert (W2) des Parameters (P2) die Detektorsignale (Sa-c) aller Detektoren (16a-c) bei bekannt fehlerfreiem Übertragungsweg (12) eine Detektion des Pilottons (6) anzeigen,
**gekennzeichnet durch**
ein auf den Parameter (P2) einwirkendes Einmessmodul (26), das mit dem jeweiligen Detektorausgang (24a-c) verbunden ist, und das dazu ausgebildet ist, den Wert (W2) (W1.B) des Parameters (P2) gemäß einem Einmesskriterium (K) anhand des Detektorsignals(Sa-c) automatisch derart einzustellen, dass bei bekannt fehlerfreiem Übertragungsweg (12) das Detektorsignal (Sa-c) eine Detektion des Pilottons (6) anzeigt,
wobei das Einmesskriterium (K) derart ausgebildet ist, dass das Einmessmodul (26) den Wert (W2) ausgehend von einem vorgebbaren Startwert (WS) aus auf einen Grenzwert (WG) hin absenkt oder erhöht, bei dem das Detektorsignal (Sac) gerade noch eine Detektion des Pilottons (6) anzeigt,
wobei das Einmesskriterium (K) derart ausgebildet ist, dass das Einmessmodul (26) den Wert (W2) vom Grenzwert (WG) aus um einen Abstandswert (WA) in diejenige Richtung absenkt oder erhöht, in der das Detektorsignal (Sa-c) die Detektion des Pilottons (6) sicher anzeigt,
wobei der Parameter (P2) eine Frequenz des Pilottons (6) ist.

2. Einmesseinheit (20) nach Anspruch 1,
**gekennzeichnet durch**
eine Ausgabeeinheit (28) zur Ausgabe des Detektorsignals (Sa-c) mindestens eines, vorzugsweise aller der Detektoren (16a-c).

3. Einmesseinheit (20) nach einem der vorhergehenden Ansprüche,
**dadurch gekennzeichnet, dass**
ein weiterer veränderbarer, den Pilotton bestimmender Parameter (P1) eine Amplitude des Pilottons (6) ist.

4. Audiosystem (2) nach einem der Ansprüche 1 bis 3,
**dadurch gekennzeichnet, dass**
es eine Einmesseinheit (20) nach einem der Ansprüche 1 bis 3 enthält.

5. Verfahren zum Betreiben einer Einmesseinheit (20) nach einem der Ansprüche 1 bis 3 oder eines Audiosystems (2) nach Anspruch 4,
**dadurch gekennzeichnet, dass**
der Parameter (P2) so eingestellt wird, dass die Detektorsignale (Sa-c) aller Detektoren (16a-c) bei bekannt fehlerfreiem Übertragungsweg (12) eine Detektion des Pilottons (6) anzeigen und
das Einmessmodul (26) den Wert (W2) des Parameters (P2) gemäß einem Einmesskriterium (K) anhand des Detektorsignals (Sa-c) automatisch derart einstellt, dass bei bekannt fehlerfreiem Übertragungsweg (12) das Detektorsignal (Sa-c) eine Detektion des Pilottons (6) anzeigt,
wobei das Einmesskriterium (K) derart ausgebildet ist, dass das Einmessmodul (26) den Wert (W2) ausgehend von einem vorgebbaren Startwert (WS) aus auf einen Grenzwert (WG) hin absenkt oder erhöht, bei dem das Detektorsignal (Sac) gerade noch eine Detektion des Pilottons (6) anzeigt,
wobei das Einmesskriterium (K) derart ausgebildet ist, dass das Einmessmodul (26) den Wert (W1,2) vom Grenzwert (WG) aus um einen Abstandswert (WA) in diejenige Richtung absenkt oder erhöht, in der das Detektorsignal (Sa-c) die Detektion des Pilottons (6) sicher anzeigt,
wobei der Parameter (P2) eine Frequenz des Pilottons (6) ist.

6. Verfahren nach Anspruch 5,
**dadurch gekennzeichnet, dass**
es vor und/oder bei Inbetriebnahme und/oder während des laufenden Betriebs des Audiosystems (2) durchgeführt wird und insbesondere zu einem späteren Zeitpunkt, insbesondere zyklisch wiederkehrend, erneut ausgeführt wird.

7. Computerprogramm mit Programmcode-Mitteln, um alle Schritte des Verfahrens nach jedem Beliebigen der Ansprüche 5 oder 6 durchzuführen, wenn das Programm auf einem Computer und/oder der Einmesseinheit (20) nach jedem Beliebigen der Ansprüche 1 bis 3 oder dem Audiosystem (2) nach Anspruch 4 ausgeführt wird.

## Claims

1. Calibration unit (20) for an audio system (2), wherein the audio system (2) comprises:
- an audio source device (8) for generating a useful audio signal (18),
- an audio target device (IOa,b) for the reception of the useful audio signal (18),
- a transmission path (12) for the useful audio signal (18) from the audio source device (8) to the audio target device (IOa,b),
- a generator (4) for the generation of a pilot tone (6), which is to be transmitted in the direction from the audio source device (8) to the audio target device (IOa,b) via the transmission path (12),
- at least one detector (16a-c) for the pilot tone (6) which is connected to the transmission path (12), having a detector output (24a-c) for a detector signal (Sa-c) which is dependent upon the detection of the pilot tone (6),
- wherein at least one of the defining parameters (P2) of the pilot tone (6) is adjustable,
wherein the calibration unit (20) incorporates an input unit (22) for optionally setting the parameter (P2) and for the input of starting values of the parameter (P2), wherein, for at least one value (W2) of the parameter (P2), the detector signals (Sa-c) of all detectors (16a-c) in a transmission path (12) which is known to be fault-free indicate the detection of the pilot tone (6), **characterized by**
a calibration module (26) which acts on the parameter (P2) and is connected to the respective detector output (24a-c) and is designed to automatically set the value (W2) of the parameter (P2) with reference to the detector signal (Sa-c), in accordance with a calibration criterion (K), such that, in a transmission path (12) which is known to be fault-free, the detector signal (Sa-c) indicates the detection of the pilot tone (6),
wherein the calibration criterion (K) is configured such that the calibration module (26), starting from a predefinable starting value (WS), decreases or increases the value (W2) to a limiting value (WG), at which the detector signal (Sac) still indicates the detection of the pilot tone (6),
wherein the calibration criterion (K) is configured such that the calibration module (26) decreases or increases the value (W2) by a marginal value (WA) from the limiting value (WG), in the direction in which the detector signal (Sa-c) securely indicates the detection of the pilot tone (6),
wherein the parameter (P2) is a frequency of the pilot tone (6).

2. Calibration unit (20) according to Claim 1,
**characterized by**
an output unit (28) for the output of the detector signal (Sa-c) from at least one, and preferably from all of the detectors (16a-c).

3. Calibration unit (20) according to either of the preceding claims,
**characterized in that**
a further variable defining parameter (P1) of the pilot tone is an amplitude of the pilot tone (6).

4. Audio system (2) according to one of Claims 1 to 3,
**characterized in that**
it contains a calibration unit (20) according to one of Claims 1 to 3.

5. Method for operating a calibration unit (20) according to one of Claims 1 to 3 or an audio system (2) according to Claim 4,
**characterized in that**
the parameter (P2) is set such that the detector signals (Sa-c) of all detectors (16a-c), in a transmission path (12) which is known to be fault-free, indicate the detection of the pilot tone (6) and
the calibration module (26) automatically sets the value (W2) of the parameter (P2) in accordance with a calibration criterion (K) with reference to the detector signal (Sa-c) such that, in a transmission path (12) which is known to be fault-free, the detector signal (Sac) indicates the detection of the pilot tone (6), wherein the calibration criterion (K) is configured such that the calibration module (26), starting from a predefinable starting value (WS), decreases or increases the value (W2) to a limiting value (WG) at which the detector signal (Sac) still indicates the detection of the pilot tone (6),
wherein the calibration criterion (K) is configured such that the calibration module (26) decreases or increases the value (W1,2) by a marginal value (WA) from the limiting value (WG) in the direction in which the detector signal (Sa-c) securely indicates the detection of the pilot tone (6),
wherein the parameter (P2) is a frequency of the pilot tone (6).

6. Method according to Claim 5,
**characterized in that**
it is executed before and/or in conjunction with commissioning and/or during the routine operation of the audio system (2), and in particular is executed again at a later time, specifically in a repeated cyclical manner.

7. Computer program with program code means for the execution of all the steps of the method according to either of Claims 5 and 6, where the program is run on a computer and/or on the calibration unit (20) according to any of Claims 1 to 3 or on the audio system (2) according to Claim 4.

## Revendications

1. Ensemble d'étalonnage (20) destiné à un système audio (2), dans lequel le système audio (2) comporte :
- un appareil formant source audio (8) destiné à générer un signal audio utile (18),
- un appareil formant cible audio (IOa,b) destiné à recevoir le signal audio utile (18),
- un trajet de transmission (12) destiné au signal audio utile (18) de l'appareil formant source audio (8) à l'appareil formant cible audio (IOa,b),
- un générateur (4) destiné à générer un son pilote (6) devant être transmis dans la direction allant de l'appareil formant source audio (8) à l'appareil formant cible audio (IOa,b) par l'intermédiaire du trajet de transmission (12),
- au moins un détecteur (16a-c) connecté au trajet de transmission (12) et destiné au son pilote (6), comprenant une sortie de détecteur (24a-c) destinée à un signal de détecteur (Sa-c) dépendant de la détection du son pilote (6),
- dans lequel au moins un paramètre (P2) déterminant le son pilote (6) est modifiable,
dans lequel l'unité d'étalonnage (20) comporte une unité d'entrée (22) permettant le réglage sélectif du paramètre (P2) et l'entrée de valeurs de départ du paramètre (P2), dans lequel, pour au moins une valeur (W2) du paramètre (P2), les signaux de détecteur (Sa-c) de la totalité des détecteurs (16a-c) indiquent une détection du son pilote (6) lorsque le trajet de transmission (12) est connu pour être exempt d'erreurs,
**caractérisé par**
un module d'étalonnage (26) qui agit sur le paramètre (P2), qui est relié à la sortie de détecteur (24a-c) correspondante et est conçu pour régler automatiquement la valeur (W2) du paramètre (P2) selon un critère d'étalonnage (K) sur la base du signal de détecteur (Sac) de telle sorte que, lorsque le trajet de transmission (12) est connu pour être exempt d'erreurs, le signal de détecteur (Sa-c) indique une détection du son pilote (6), dans lequel le critère d'étalonnage (K) est conçu de telle sorte que le module d'étalonnage (26), partant d'une valeur de départ (WS) prédéterminable, abaisse ou augmente la valeur (W2) jusqu'à une valeur limite (WG) à laquelle le signal de détecteur (Sac) indique simplement la détection du son pilote (6),
dans lequel le critère d'étalonnage (K) est conçu de telle sorte que le module d'étalonnage (26) abaisse ou augmente la valeur (W2) par rapport à la valeur limite (WG) d'une valeur de distance (WA) dans la direction dans laquelle le signal de détecteur (Sa-c) indique de manière fiable la détection du son pilote (6),
dans lequel le paramètre (P2) est une fréquence du son pilote (6).

2. Ensemble d'étalonnage (20) selon la revendication 1,
**caractérisé par** une unité de sortie (28) destinée à délivrer le signal de détecteur (Sa-c) d'au moins l'un, et de préférence de la totalité, des détecteurs (16a-c).

3. Ensemble d'étalonnage (20) selon l'une des revendications précédentes, **caractérisé en ce qu'**un autre paramètre modifiable (P1) déterminant le son pilote est une amplitude du son pilote (6).

4. Système audio (2) selon l'une des revendications 1 à 3, **caractérisé en ce qu'**il comporte un ensemble d'étalonnage (20) selon l'une des revendications 1 à 3.

5. Procédé pour faire fonctionner un ensemble d'étalonnage (20) selon l'une des revendications 1 à 3 ou un système audio (2) selon la revendication 4,
**caractérisé en ce que**
le paramètre (P2) est réglé de telle sorte que les signaux de détecteur (Sa-c) de la totalité des détecteurs (16a-c) indiquent une détection du son pilote (6) lorsque le trajet de transmission (12) est connu pour être exempt d'erreurs et
le module d'étalonnage (26) règle automatiquement la valeur (W2) du paramètre (P2) selon un critère d'étalonnage (K) sur la base du signal de détecteur (Sac) de telle sorte que le signal de détecteur (Sa-c) indique une détection du son pilote (6) lorsque le trajet de transmission (12) est connu pour être exempt d'erreurs, dans lequel le critère d'étalonnage (K) est conçu de telle sorte que le module d'étalonnage (26), partant d'une valeur de départ (WS) prédéterminable, abaisse ou augmente la valeur (W2) jusqu'à une valeur limite (WG) à laquelle le signal de détecteur (Sac) indique simplement la détection du son pilote (6),
dans lequel le critère d'étalonnage (K) est conçu de telle sorte que le module d'étalonnage (26) abaisse ou augmente la valeur (W1,2) par rapport à la valeur limite (WG) d'une valeur de distance (WA) dans la direction dans laquelle le signal de détecteur (Sa-c) indique de manière fiable la détection du son pilote (6),
dans lequel le paramètre (P2) est une fréquence du son pilote (6).

6. Procédé selon la revendication 5, **caractérisé en ce qu'**il est mis en œuvre avant et/ou pendant la mise en fonctionnement et/ou pendant le fonctionnement continu du système audio (2) et est notamment mis en œuvre à nouveau à un instant ultérieur, en particulier de manière cyclique.

7. Programme d'ordinateur comprenant un moyen à code de programme destiné à exécuter toutes les étapes du procédé selon l'une des revendications 5 ou 6 lorsque le programme est exécuté sur un ordinateur et/ou sur l'ensemble d'étalonnage (20) selon l'une des revendications 1 à 3 ou sur le système audio (2) selon la revendication 4.
